# EUROPEAN PATENT APPLICATION

(11) **EP 2 216 808 A2**
(43) Date of publication of application: **11.08.2010**
(21) Application number: 09004891.9
(22) Date of filing: 02.04.2009
(51) Int. Cl.: H01L 21/48

(54) **Method of making a heat sink**

(30) Priority: 10.02.2009 TW 98104258
(71) Applicant: Giga-Byte Technology Co., Ltd., Taipei County (TW)
(72) Inventor: The designation of the inventor has not yet been filed
(74) Representative: Brandenburger, Karin

(57) **Abstract**

A method of making a heat sink is disclosed. The heat sink includes a first heat conductive plate, a second heat conductive plate and a fin assembly. The first heat conductive plate has a plurality of first protrusions uniformly spaced apart by through holes. The second heat conductive plate is formed with a plurality of second protrusions parallel to one another. The fin assembly includes a plurality of heat-dissipation plates. The method includes the steps of placing the first heat conductive plate on the fin assembly; placing the second heat conductive plate on the first heat conductive plate so as to have each of the heat-dissipation plates be sandwiched between a pair of the first and second conductive plates; and punching the assembled first and second conductive plates and the fin assembly to have the same tightly bonded together.

## Description

### BACKGROUND OF THE INVENTION

### Field of the Invention

The present invention generally relates to the method of making a heat sink, and more particular, relates to the procedure for assembling a fin assembly to a heat conductive plate.

### Description of the Related Art

The conventional heat sink is assembled with metalwork of a fin assembly and heat conductive plates basically. Solder paste or heat conduction glue was used to stick them together.

According to Taiwan patent no. M337724, which brings up the statement that screwing the screw to some copper sandwich components and some heat-dissipation plates to assemble a heat dissipation module, wherein merely screwing is not easy to force the copper sandwich components to attach the heat-dissipation plates tightly. And still need to solder the copper sandwich components and the heat-dissipation plates together.

The heat sink or heat-dissipation module above-mentioned still needs the soldering operation, and also needs screwing operation for closing tightly, which is time-consuming and work-requiring and still needs to be improved.

### BRIEF SUMMARY OF THE INVENTION

Further scope of applicability of the present invention will become apparent from the detailed description given hereinafter. However, it should be understood that the detailed description and specific examples, while indicating preferred embodiments of the Invention, are given by way of illustration only, since various changes and modifications within the spirit and scope of the invention will become apparent to those skilled in the art from this detailed description.

### BRIEF DESCRIPTION OF THE DRAWINGS

The present invention will become more fully understood from the detailed description given hereinbelow and the accompanying drawings which are given by way of illustration only, and thus are not limitative of the present invention, and wherein:
FIG. 1 is a breakdown perspective view in accordance with a preferred embodiment of the present invention;
FIG. 2 is a schematic diagram of assembling process in accordance with a preferred embodiment of the present invention;
FIG. 3 is a partial view of section of the first heat conductive plate in accordance with a preferred embodiment of the present invention;
FIG. 4 is a perspective view of assembly circuit board in accordance with a preferred embodiment of the present invention;
FIG. 5 is a A-A section view derived from FIG. 3;
FIG. 6 is a perspective view of the second heat conductive plate in accordance with a preferred embodiment of the present invention;
FIG. 7 is a perspective view of another first heat conductive plate in the present invention;
FIG. 8 is a partial detail view of another second heat conductive plate;
FIG. 9 is a partial detail view of another second heat conductive plate in accordance with an embodiment with the present invention;
FIG. 10 is a schematic diagram of assembly of another first heat conductive plate and the other second conductive plate;
FIG. 11 is a partial view of section of assembly of the other first heat conductive plate and another second conductive plate.

### DETAILED DESCRIPTION OF THE INVENTION

The present invention will now be described in detail with reference to the accompanying drawings, wherein the same reference numerals will be used to identify the same or similar elements throughout the several views. It should be noted that the drawings should be viewed in the direction of orientation of the reference numerals.

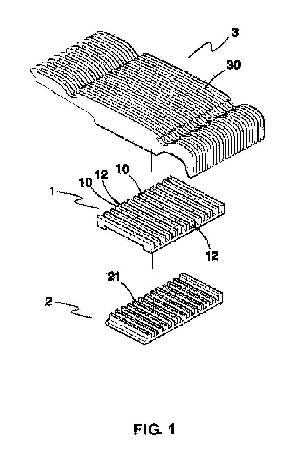

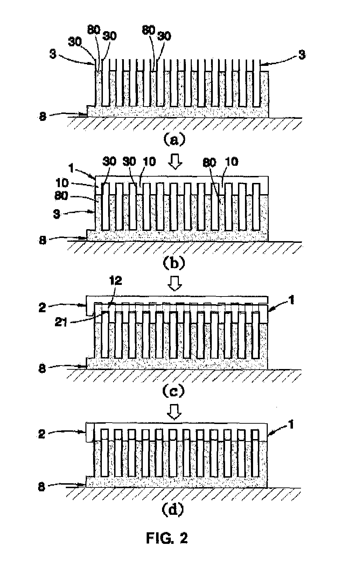

Referring to FIG. 1 and FIG. 2, an embodiment of the present invention, wherein the method comprising steps below:
Referring to FIG. 1, providing a first heat conductive plate 1;
Referring to FIG. 1, providing a second heat conductive plate 2;
Referring to FIG. 1, providing a fin assembly 3;
Referring to FIG. 2 (b), stacking the first heat conductive plate 1 onto the fin assembly 3;
Referring to FIG. 2(c), stacking the second heat conductive 2 onto the first heat conductive 1; and
Punching the first heat conductive plate 1 and the second heat conductive plate 2 make them close tightly together.

For the time being, fulfill the task of assembling the first heat conductive plate, the second heat conductive plate and fin assembly into a heat sink. In the steps above-mentioned, no need of soldering or screwing, comparing with conventional technology, obviously have the advantage of timesaving, laborsaving, and low-cost.

The above-mentioned procedure, due to the speedy assembling needs usually need an appropriate mold and punch press.

For this reason, before the step above-mentioned of stacking the first heat conductive plate 1 onto the fin assembly 3, according to FIG. 2 (a), it would be best to provide a mold 8, and put the fin assembly 3 on the mold 8.

In order to accomplish the method of above-mentioned invention, the method of punching can achieve the purpose to assemble heat sink speedily. The structures of the first heat conductive plate 1, the second conductive plate 2, and the fin assembly 3 need to cooperate with each other. The manufacturing procedure for how they stack up will illustrate afterward.

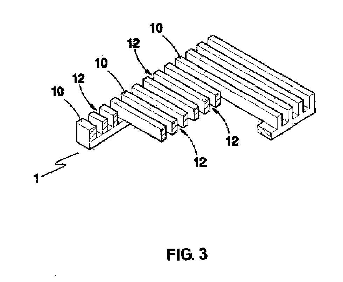

Referring FIG. 1 and FIG. 3. the first heat conductive plate 1 has a plurality of first protrusions 10 on the same side and a plurality of passageways 12 interlaced. The structure of middle section of the passageways 12 are all hollow-through, except two side parts. The second heat conductive plate 2 has a plurality of second protrusions 21 on the same side, which size and position are exactly fit for wedging the passageways 12. The fin assembly 3 has a plurality of heat-dissipation plates. Each component above-mantioned can choose from the same or different heat conduction material, such as aluminum or copper. It would be beat to use all same material, like aluminum, for the convenience of manufacture. And furthermore, the first heat conductive plate 1 and the second heat conductive plate 2 can be electroplated in different color or can be printed with different color or patterns..

The mold 8 has a plurality of raised supporters 80 on one side. According to the step shown in FIG. 2 (a), each heat-dissipation plate 30 on the fin assembly 3 attaches to a wide side of the corresponding supporters 80 on the mold 8.

According to the step shown in FIG.2 (b), the top of each first protrusion 10 on the first heat conductive plate 1 fronts straight the top of corresponding supporter 80 on the mold 8. Each separate heat-dissipation plate 30 on the fin assembly 3 attaches to a wide side of the corresponding first protrusion 10.

According to the step shown in FIG. 2 (c), each second protrusion 21 on the second heat conductive plate 2 meets separately the corresponding passageway 12 on the first heat conductive plate 1.

Using a punching machine punches the second heat conductive plate 2 for tightly closing the first heat conductive plate and the second heat conductive plate together, so as to complete the heat sink.

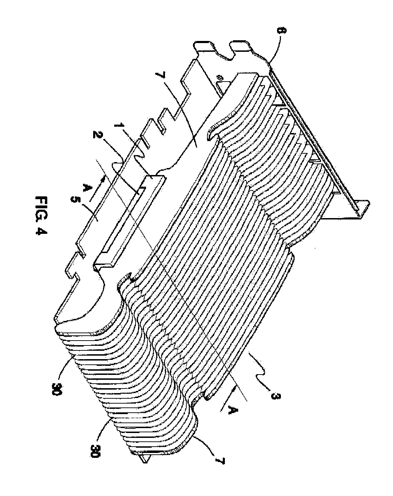

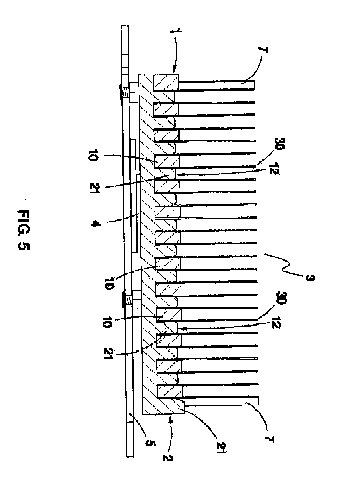

Referring to FIG. 4 and FIG. 5, presenting the arrangement of the heat sink and its utilization with a circuit board 5, wherein the first heat conductive plate 1 and the second heat conductive plate 2 tightly close together; the second protrusions 21 wedge in the passageways 12 on the first conductive plate separately and therefore Interlace with the first protrusions 10; and the heat-dissipation plates 30 of the fin assembly 3 stand on the first heat conductive plate 1 and the second heat conductive plate 2, and part of each separate heat-dissipation plates 30 is sandwiched tightly between interlaced the first protrusion 10 and the second protrusion 21. Wherein there are a backboard 6 and two baffle plates 7 to make the frame around the fin assembly 3.

When the element 4, like a central processing unit (CPU), on the circuit board 5 works to cause waste heat, the waste heat will conduct from bottom of the second heat conductive plates 2 to the second protrusions 21 and to the first protrusions 10 on the first conductive plate 1, so as to make each heat-dissipation plate 30, which is sandwiched between a pair of the first protrusion 10 and the second protrusion 21, can absorb and dissipate the waste heat from every pair of the first protrusion 10 and the second protrusion 21.

Because each pair of the first protrusion 10 and the second protrusion 21 contacts the sandwiched heat-dissipation plate 30 with large area, the heat-dissipation efficiency is quite excellent by using the method of making a heat sink In accordance with the present invention.

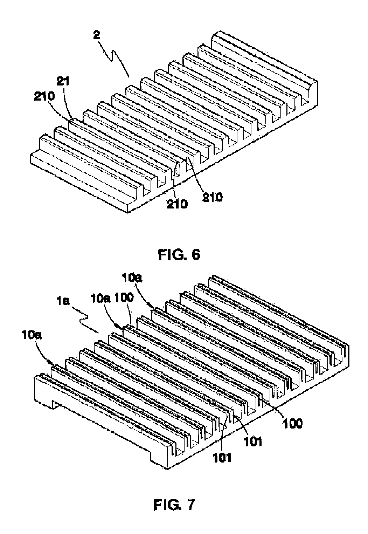

Referring to FIG. 6, a chamfer 210 is formed along each of two relative long sides on the top of the second protrusion 21. Therefore, during the punch procedure above-mentioned, the second protrusion 21 can wedge in the passageway 12 on the first heat conductive plate 1 more smoothly.

Referring to FIG. 7, the other first heat conductive plate 1a resembles the first heat conductive plate 1 above-mentioned, but differs in a V-shape passageway 100 which is formed in each of the first protrusion 10a. The length of V-shape passageway 100 is same to the length of the first protrusion 10a. and the depth of V-shape passageway 100 is close to the bottom of the first protrusion 10a. For the reason, the V-shape passageway 100 divides the first protrusion 10a into two branches 101.

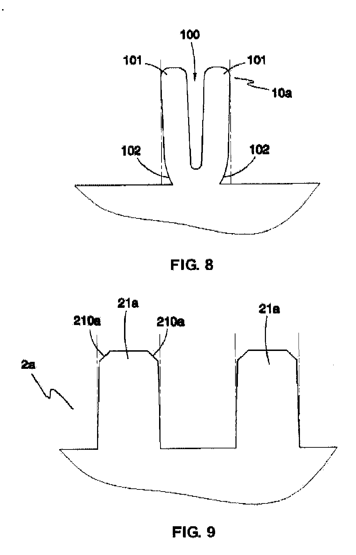

Referring to FIG. 8, a chamfer 102 is formed along each of two relative long sides on the bottom of the first protrusion 10a., and two branches 101 on each the first protrusion 10a lean outward slightly.

Referring to FIG. 9, the other second heat conductive plate 2a resembles the second heat conductive plate 2 above-mentioned, but differs in that each second protrusion 21a is asked to gradually narrow down from the bottom to the top slightly.

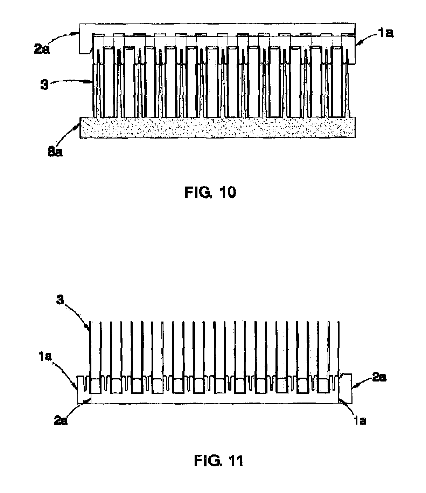

Referring to FIG. 10, the arrangement of the first heat conductive 1a, the second heat conductive 2a and fin assembly 3 being put on the mold 8; wherein the procedures are same to FIG. 2 (a)∼ FIG. 2 (c).

Referring to FIG. 11, the heat sink is assembled with the first heat conductive plate 1a, the second heat conductive plate 2a, and the fin assembly 3; wherein by using punch press above-mentioned for assembling the heat sink, and the procedure is same to FIG. 2 (d). What needs to be pointed out is when the second protrusion 21a separately wedges in the passageways 12a, each of two branches 101 on the first protrusion 10a will be pushed inwards to become straight by wedging the corresponding second protrusion 21a.

With the design of the first heat conductive plate 1a and the second heat conductive plate abova-mentioned, the first heat conductive plate 1a and the second heat conductive 2a can not only close together tightly but also smooth away the tolerance occurring during manufacturing, which finally enables both the first heat conductive 1a and the second heat conductive 2a close together tightly and enables each heat-dissipation plate of fin assembly 30 to be sandwiched between every pair of the second protrusion 21a and the first protrusion 10a tightly.

While the invention has been described by way of example and in terms of the preferred embodiment, it is to be understood that the invention is not limited to the disclosed embodiments, and it will be obvious that the same may be varied in many ways. Such variations are not to be regarded as a departure from the spirit and scope of the invention, and all such modifications as would be obvious to one skilled in the art are intended to be included within the scope of the following clams.

## Claims

1. A method of making a heat sink, comprising:
providing a first heat conductive plate, having a plurality of first protrusions placed on the same side and a plurality of passageways interlaced with said first protrusions;
providing a second heat conductive plate, having a plurality of second protrusions placed on the same side and the size and position of said second protrusions is exactly fit for wedging said passageways in;
providing a fin assembly, having a plurality of heat-dissipation plates;
stacking said first heat conductive plate on said fin assembly, and making each heat-dissipation plate of said fin assembly attaches to a wide surface of said corresponding first protrusion on said first heat conductive plate;
stacking said second heat conductive plate on said first heat conductive plate, and making each said second protrusion on said second heat conductive plate separately meet corresponding passageway on said first heat conductive plate: and
punching said first heat conductive plate and said second heat conductive plate to make them tightly stacked up and make each heat-dissipation plate of said fin assembly be partly sandwiched in between each pair of interlaced said first protrusion and said second protrusion,

2. The method as claimed in claim 1, wherein comprise:
forming a chamfer along each of the two relative long sides on the top of said second protrusion.

3. The method as claimed in claim 1, wherein comprise:
forming a V-shape passageway in each said first protrusion for dividing each said first protrusion into two branches, and said two branches leaning outward slightly.

4. The method as claimed In claim 3, wherein comprise:
forming a chamfer along each of the two relative long sides on the bottom of said first protrusion.

5. The method as claimed in claim 4, wherein comprise making the width of each said second protrusion gradually narrows down from the bottom to the top slightly, and forming a chamfer along each of two relative long sides on the top of said second protrusion.

6. The method as claimed in claim 1 to 5, wherein comprise:
providing a mold; putting said fin assembly on said mold first; putting said first heat conductive plate on said mold; and wherein there is a plurality of raised supporters on a side of said mold, the top of each said first protrusion on said first heat conductive plate straightly meets to the top of said corresponding supporters, and each heat-dissipation plate of said fin assembly attaches to a long side of said corresponding supporter on said mold.
